(19) Europäisches Patentamt
European Patent Office
Office européen des brevets

(11) **EP 4 025 022 A1**

(12) **EUROPEAN PATENT APPLICATION**
published in accordance with Art. 153(4) EPC

(43) Date of publication:
**06.07.2022 Bulletin 2022/27**

(21) Application number: **20856650.5**

(22) Date of filing: **27.03.2020**

(51) International Patent Classification (IPC):
***H05K 7/20*** (2006.01)

(86) International application number:
**PCT/CN2020/081529**

(87) International publication number:
**WO 2021/036249 (04.03.2021 Gazette 2021/09)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.08.2019 CN 201910818019**

(71) Applicant: **Huawei Technologies Co., Ltd.
Longgang District
Shenzhen,
Guangdong 518129 (CN)**

(72) Inventors:
• **PENG, Yaofeng**
  **Shenzhen, Guangdong 518129 (CN)**
• **YIN, Jianqiang**
  **Shenzhen, Guangdong 518129 (CN)**

(74) Representative: **Grünecker Patent- und
Rechtsanwälte
PartG mbB
Leopoldstraße 4
80802 München (DE)**

(54) **HEAT DISSIPATION DEVICE, ELECTRONIC APPARATUS, AND AUTOMOBILE**

(57)    This application provides a heat radiator, an electronic device, and a vehicle. The heat radiator includes a heat dissipation plate, and the heat dissipation plate is configured to be attached and fastened to the electronic device. A plurality of circumferentially disposed heat dissipation regions are disposed on the heat radiator. A plurality of first heat dissipation fins disposed in parallel with each other are disposed at intervals in each heat dissipation region. A heat dissipation channel is formed between adjacent first heat dissipation fins. One end that is of the heat dissipation channel and that is away from a center of the heat dissipation plate is an air inlet, and a direction that is above the heat dissipation channel and that is towards a hollow region is an air outlet. Heat dissipation is performed by using the foregoing plurality of heat dissipation regions, so that a quantity of air inlets and a quantity of air outlets of the heat radiator are increased. In addition, air can enter the heat radiator in different directions, thereby improving a heat dissipation effect of the heat radiator.

FIG. 1

EP 4 025 022 A1

**Description**

**TECHNICAL FIELD**

This application relates to the field of heat dissipation technologies, and in particular, to a heat radiator, an electronic device, and a vehicle.

**BACKGROUND**

In view of practicality and costs, heat dissipation is more likely to be performed for an electronic component whose heat is to be dissipated in an electronic device (for example, an automated driving platform, edge computing product, or a terminal) through passive natural convection heat dissipation. A heat radiator includes a heat dissipation plate and a heat dissipation channel that is formed by using a plurality of parallel heat dissipation fins disposed on the heat dissipation plate and that is open at two ends. Cold air may flow into the heat dissipation channel through the openings. When the electronic component whose heat is to be dissipated emits heat, surrounding temperature is increased, so that the cold air is heated and rises up, and the heat emitted by the electronic component whose heat is to be dissipated is conducted to the outside of the heat radiator. However, as a processing capability and power consumption of the electronic device are improved, the foregoing heat dissipation manner cannot meet a heat dissipation requirement of the electronic device. Therefore, how to provide an effective heat radiator to dissipate heat for the electronic device becomes a technical problem that needs to be resolved urgently.

**SUMMARY**

This application provides a heat radiator and an electronic device, to improve a heat dissipation effect of the heat radiator on an electronic component whose heat is to be dissipated in the electronic device.

According to a first aspect, a heat radiator is provided. The heat radiator is used in an electronic device, and is configured to dissipate heat for an electronic device. The heat radiator includes a heat dissipation plate, and the heat dissipation plate is configured to be fastened to the electronic device. The heat radiator further includes a plurality of circumferentially disposed heat dissipation regions. A plurality of first heat dissipation fins disposed in parallel with each other are disposed in each heat dissipation region. Each first heat dissipation fin is fixedly connected to the heat dissipation plate. A first heat dissipation channel is surrounded by the plurality of first heat dissipation fins disposed at intervals. One end that is of the first heat dissipation channel and that is away from a center of the heat dissipation plate is an air inlet, and a direction that is above each first heat dissipation channel and that is towards a hollow region is an air outlet. In the foregoing technical solution, heat dissipation is performed by using a plurality of heat dissipation regions, and opening directions of air inlets in different heat dissipation regions are different, so that a quantity of air inlets of the heat radiator is increased, and air can enter in different directions, thereby improving a heat dissipation effect.

In a possible design, opening directions of air inlets in different heat dissipation regions in the plurality of heat dissipation regions are different. In this way, it is ensured that the air inlet of the heat radiator is not affected by a wind direction, thereby conducting heat of a chip whose heat is to be dissipated, and effectively dissipating heat for the chip whose heat is to be dissipated.

In another possible design, the plurality of first heat dissipation fins in each heat dissipation region are arranged at equal intervals. Therefore, a ventilation effect is ensured, and resistance of air in the heat dissipation channel is reduced.

In another possible design, the plurality of first heat dissipation fins in each heat dissipation region are arranged at unequal intervals. Space of the heat dissipation channel may be designed with reference to a specific implementation requirement, to effectively dissipate heat for a heat dissipation component of a specified model. In addition, the plurality of first heat dissipation fins are disposed at unequal intervals, so that a quantity of first heat dissipation fins in the heat radiator can also be reduced, thereby reducing a cost of the entire heat radiator.

In another possible design, the plurality of first heat dissipation fins in each heat dissipation region are arranged in a single row, and lengths of the first heat dissipation fins gradually decrease from the middle to two sides. Therefore, the plurality of heat dissipation regions can be symmetrically disposed on the heat dissipation plate.

In another possible design, adjacent heat dissipation regions are spaced from each other by a gap, and a second heat dissipation channel is formed between the adjacent heat dissipation regions. The second channel may also be used to implement ventilation, thereby further improving a heat dissipation effect.

In another possible design, there are four heat dissipation regions, the four heat dissipation regions are symmetrically disposed, and areas of the heat dissipation regions are the same. Therefore, air can enter in four directions, thereby improving a heat dissipation effect.

In another possible design, when adjacent heat dissipation regions are spaced from each other by a gap, gaps between the heat dissipation regions form an X-shaped ventilation channel, thereby further improving a heat dissipation effect.

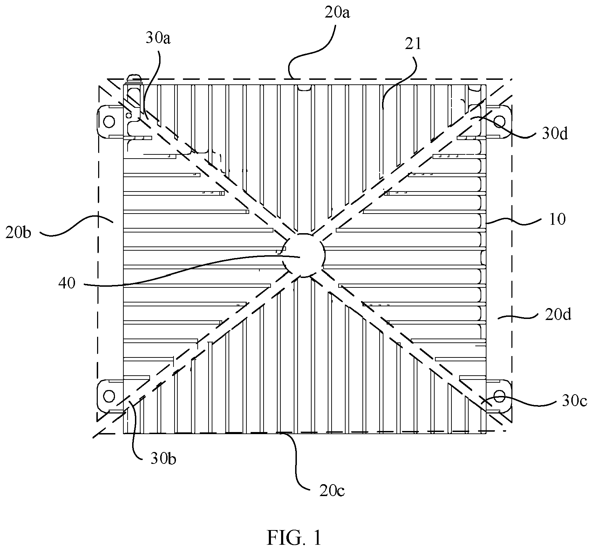

In another possible design, midpoints of opposite edges of the heat radiator are connected to each other to form a "cross" structure, and a hollow region similar to a hollow region shown in FIG. 1 exists in a center part, to help form a siphon cavity. Each heat dissipation region also includes a plurality of first heat dissipation fins, and a first heat dissipation channel is formed between two adjacent heat dissipation fins. A second heat dissipation channel is formed in a gap between different heat dissipation regions. Optionally, a thermally conductive area may be increased by using second heat dissipation fins, to improve a thermally conductive effect.

In another possible design, a hollow siphon cavity is surrounded by the plurality of heat dissipation regions, and air outlets in the plurality of heat dissipation regions are connected to the siphon cavity, thereby improving an air flow effect, and further improving a heat dissipation effect.

In another possible design, each heat dissipation region further includes a plurality of second heat dissipation fins that are disposed at intervals and that are inserted in the plurality of first heat dissipation fins, and a length direction of each second heat dissipation plate is unparallel with a length direction of each first heat dissipation fin. A heat dissipation area is increased by using the added second heat dissipation fins, thereby improving a heat dissipation effect of the heat radiator.

In another possible design, a length direction of the second heat dissipation fin is perpendicular to the length direction of the first heat dissipation fin. Air flowing through the first heat dissipation fin rises up after temperature is increased, and the second heat dissipation fin is perpendicular to the first heat dissipation fin to increase a contact area with the air.

In another possible design, a slot is disposed on one side that is of the first heat dissipation fin and that is away from the heat dissipation plate, and the second heat dissipation fin is inserted in the slot. The second heat dissipation fin is fixedly connected to the first heat dissipation fin in an insertion manner.

In another possible design, the second heat dissipation fin is disposed to be stacked with the first heat dissipation fin, and the second heat dissipation fin is fixedly connected to the first heat dissipation fin through welding.

In another possible design, each second heat dissipation fin and the heat dissipation plate are spaced from each other by a specified distance. The gap is set to facilitate air flow.

In another possible design, the specified distance is between 3 mm and 8 mm. For example, different distances such as 3 mm, 4 mm, 5 mm, 7 mm, and 8 mm may be used.

In another possible design, a thickness of the first heat dissipation fin is greater than a thickness of the second heat dissipation fin, thereby improving a heat dissipation effect.

In another possible design, when intervals between adjacent first heat dissipation fins in all regions are the same, heat dissipation channels in two heat dissipation regions that are disposed to be opposite to each other may be connected. For example, as shown in FIG. 1, in a heat dissipation region 20a and a heat dissipation region 20c, a plurality of first heat dissipation fins in a same heat dissipation region are disposed at equal intervals and in parallel, so that heat dissipation channels that are disposed to be opposite to each other and that are in the heat dissipation region 20a and the heat dissipation region 20c are connected. Similarly, heat dissipation channels that are disposed to be opposite to each other and that are in a heat dissipation region 20b and a heat dissipation region 20d are also connected. Another connected heat dissipation channel is further formed in opposite heat dissipation regions in the foregoing heat radiator. When heat is unevenly generated in different regions of a component whose heat is to be dissipated, or when a same heat radiator dissipates heat for a plurality of components and the components generate heat differently, in the foregoing structure, another region may be used to assist in dissipating heat for a high-power heat dissipation region in the component whose heat is to be dissipated or a high-power component, thereby improving a heat dissipation effect of the heat radiator.

In another possible design, intervals between heat dissipation fins 21 in different heat dissipation regions may be the same or different, and may be set based on a specific requirement during specific implementation. Considering that different components whose heat is to be dissipated and different parts of a same heat dissipation component generate heat differently, the plurality of heat dissipation regions in the heat radiator may dissipate heat for different types of components whose heat is to be dissipated or for different parts of a same heat radiator. Considering heat dissipation effects of different heat dissipation regions on the component whose heat is to be dissipated or different parts of the component whose heat is to be dissipated, the intervals between the first heat dissipation fins in each heat dissipation region may be set based on a specific implementation requirement, to form different quantities of heat dissipation air ducts, thereby effectively dissipating heat for a high-power component whose heat is to be dissipated or different regions of a same component whose heat is to be dissipated.

According to a second aspect, an electronic device is provided, where the electronic device includes a device body, an electronic component whose heat is to be dissipated and that is disposed in the device body, and the heat radiator that is disposed on the device body and that is in any one of the foregoing possible designs, and the heat radiator is connected to the electronic component whose heat is to be dissipated. Heat dissipation is performed by using a plurality of heat dissipation regions, and opening directions of air inlets in different heat dissipation regions are different, so that a quantity of air inlets of the heat radiator is increased, and air can enter in different directions, thereby improving a heat dissipation effect.

In a possible design, the electronic device body and the heat dissipation plate have an integral structure. The electronic component whose heat is to be dissipated is in contact with the device body, that is, is in contact with the heat radiator. Heat generated by the electronic component whose heat is to be dissipated is transferred to the heat radiator for heat dissipation. Because the heat dissipation plate of the heat radiator and the electronic device body have an integral structure, heat dissipation fins of the heat radiator may be directly disposed on the electronic device body, and the heat of the electronic component whose heat is to be dissipated may be directly transferred to the heat dissipation fins by using the device body, thereby reducing components through which the heat is transferred, and improving a heat dissipation effect.

According to a third aspect, a vehicle is provided, where the vehicle includes a vehicle body, and the heat radiator that is disposed in the vehicle body and that is in any one of the foregoing possible designs or the electronic device that is disposed in the vehicle body. Heat dissipation is performed by using a plurality of heat dissipation regions, and opening directions of air inlets in different heat dissipation regions are different, so that a quantity of air inlets of the heat radiator is increased, and air can enter in different directions, thereby improving a heat dissipation effect.

In this application, based on the designs provided in the foregoing aspects, the designs may be further combined to provide more designs.

## BRIEF DESCRIPTION OF DRAWINGS

FIG. 1 is a top view of a first heat radiator according to this application;
FIG. 2 is a three-dimensional diagram of a first heat radiator according to this application;
FIG. 3 is a schematic diagram of air flow of a first heat radiator according to this application;
FIG. 4 is a top view of a second heat radiator according to this application;
FIG. 5 is a three-dimensional diagram of a second heat radiator according to this application;
FIG. 6 is a schematic diagram of air flow of a second heat radiator according to this application;
FIG. 7 is a sectional view of a use status of a second heat radiator according to this application; and
FIG. 8 is a schematic structural diagram of a vehicle according to this application.

## DESCRIPTION OF EMBODIMENTS

First, an application scenario of a heat radiator provided in this application is described. The heat radiator provided in this application is used in an electronic device such as an in-vehicle computation apparatus, a memory, and a server. For ease of description, the following content is described by using an example in which the electronic device is an in-vehicle computation apparatus. The in-vehicle computation apparatus is used in automated driving (automated driving) of an intelligent vehicle. The intelligent vehicle includes an electric vehicle that supports unmanned driving (unmanned driving), driver assistance/ADAS (driver assistance/ADAS), intelligent driving (intelligent driving), connected driving (connected driving), intelligent network driving (intelligent network driving), and car sharing (car sharing), or a gasoline-driven vehicle. The in-vehicle computation apparatus is configured to control and monitor a driving status of the intelligent vehicle, and includes but is not limited to an in-vehicle mobile data center (mobile data center, MDC), and a hardware monitor interface (hardware monitor interface, HMI), an in-vehicle infotainment (in-vehicle infotainment, IVI) controller, a body control module (body control module, BCM), and a vehicle control unit (vehicle control unit, VCU) that implement a function of a human-computer interaction controller. The in-vehicle computation apparatus may specifically have a chip with a computation and processing capability, or may be a set of a plurality of components such as a processor and a memory that are integrated into a printed circuit board (printed circuit board, PCB). The processor includes but is not limited to a central processing unit (central processing unit, CPU), a general-purpose processor, a digital signal processor (digital signal processing, DSP), an application-specific integrated circuit (application-specific integrated circuit, ASIC), a field-programmable gate array (field-programmable gate array, FPGA) or another programmable logic device, a discrete gate or transistor logic device, a discrete hardware component, a graphics processing unit (graphics processing unit, GPU), a system on chip (system on chip, SoC), and an artificial intelligence (artificial intelligence, AI) chip. The general-purpose processor may be a microprocessor, any conventional processor, or the like. It may be learned from the foregoing description that because a chip with a relatively large computation amount is disposed in the in-vehicle computation apparatus, there is a relatively high heat dissipation requirement when the apparatus is used. Therefore, this application provides a heat radiator to improve a heat dissipation effect of the in-vehicle computation apparatus. During use, the heat radiator is fixedly connected to the in-vehicle computation apparatus, and is configured to conduct heat of the in-vehicle computation apparatus to the outside of the in-vehicle computation apparatus, to ensure reliable running of the in-vehicle computation apparatus. Optionally, in addition to dissipating heat for the chip that has a computation capability, the heat radiator provided in this application may dissipate heat for another type of high-power electronic component whose heat is to be dissipated in the electronic device, for example, a network adapter and a hard disk.

Next, a working process of the heat radiator provided in this application is further described with reference to the Newton's law of cooling in convective heat transfer. A specific formula is as follows:

In convective heat transfer, the Newton's law of cooling is used for calculation:

$$\varnothing = h_c A(t_w - t_f),$$

where

in the formula, $h_c$ is a convective heat transfer coefficient with a unit of W/($m^2$ * °C);
A is a convective heat transfer area with a unit of $m^2$;
$t_w$t is temperature of a hot surface with a unit of °C;
$t_f$ is temperature of cooling fluid with a unit of °C; and
$\varnothing$ is heat with a unit of W.

It may be learned from the foregoing formula that the following methods may be used to improve heat dissipation efficiency of the heat radiator:

Method 1: The heat transfer area A (that is, a fin area) is increased, for example, a quantity of fins is increased. A heat dissipation capability of the heat radiator is first increased with the quantity of fins. However, when the quantity of fins is increased to a specific quantity, air flow resistance is increased and an air flow speed is decreased under an action of a viscous force on a fin surface. If the quantity of fins is further increased, a heat transfer capability of the heat radiator is not increased. Instead, the heat dissipation capability of the heat radiator is decreased. Therefore, the quantity of fins cannot be increased unlimitedly to improve the heat transfer capability.
Method 2: The convective heat transfer coefficient $h_c$ is increased. Natural convective heat transfer is mainly as follows: Buoyancy is formed due to a density difference between cold air and hot air, so that the hot air rises up and the cold air is supplemented, thereby removing heat on a fin surface of the heat radiator. To increase the convective heat transfer coefficient, the cold air needs to be supplemented easily.

Further, the heat radiator provided in this application is further described with reference to the accompanying drawings of this application.

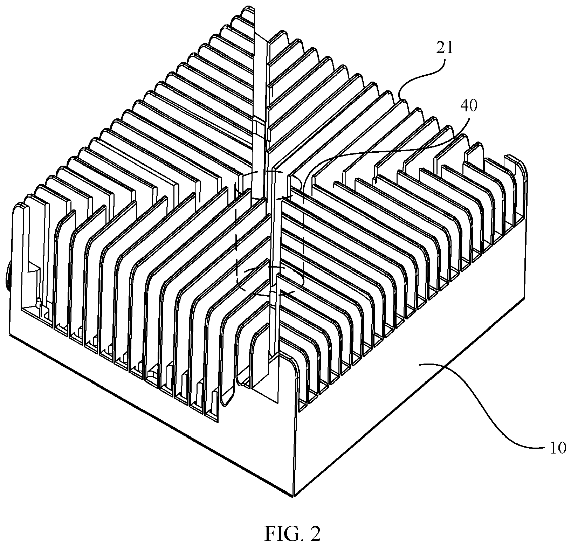

FIG. 1 is a top view of a heat radiator according to this application. FIG. 2 is a side view of a heat radiator according to this application. As shown in the figure, the heat radiator includes a heat dissipation plate 10. When connecting to an electronic device, the heat dissipation plate 10 is fixedly connected to the electronic device. Optionally, a housing of the electronic device may be used as the heat dissipation plate 10. For ease of description, the following content in this application is described by using the heat dissipation plate 10 shown in FIG. 1 as an example.
As shown in FIG. 1, the heat dissipation plate 10 is a rectangular metal plate, and is a heat dissipation plate 10 produced from a common thermally conductive material such as a copper plate or an aluminum plate. In addition, an area of an effective heat dissipation surface of the heat dissipation plate 10 needs to be greater than or equal to a surface area of a component or device whose heat is to be dissipated. That is, an area of a surface that is of the heat dissipation plate 10 and that is used to conduct heat of the electronic component whose heat is to be dissipated is equal to an area of a region that is of the electronic device and in which heat needs to be dissipated, or an area of a surface that is of the heat dissipation plate 10 and that is used to conduct heat of the electronic component whose heat is to be dissipated is greater than an area of a region that is of the electronic device and in which heat needs to be dissipated. A shape of the heat dissipation plate is not limited in this application, and a specific shape of the heat dissipation plate may be correspondingly adjusted based on an electronic device to which the heat dissipation plate adapts during specific implementation and a shape and a size of the component whose heat is to be dissipated.
The heat radiator shown in FIG. 1 includes four heat dissipation regions. Diagonals of the heat radiator may be intersected to form four triangle regions, each triangle region is a heat dissipation region, and areas of the heat dissipation regions are the same. In a specific implementation process, the heat dissipation plate may be first divided into four heat dissipation regions, and then heat dissipation fins are disposed in each heat dissipation region, to form a heat dissipation channel. An area of an effective heat dissipation surface of the heat radiator may be greater than or equal to the surface area of the electronic component whose heat is to be dissipated.
The heat radiator provided in this application may dissipate heat for one component whose heat is to be dissipated in the electronic device, or may simultaneously dissipate heat for a plurality of components whose heat is to be dissipated in a same electronic device. When the heat radiator dissipates heat for one component whose heat is to be dissipated, the area of the effective heat dissipation surface of the heat radiator may be greater than or equal to a surface area of the component whose heat is to be dissipated. When the heat radiator dissipates heat for a plurality of heat dissipation components, the area of the effective heat dissipation surface of the heat radiator may be greater than or equal to a sum of surface areas of all the components whose heat is to be dissipated.
The heat dissipation plate 10 has two opposite surfaces. For ease of description, the two surfaces may be respectively named a first surface and a second surface. The first surface of the heat dissipation plate 10 is a surface away from the electronic component whose heat is to be dissipated. The second surface is a surface connected to the component whose heat is to be dissipated, is used to be attached and connected to the electronic component whose heat is to be dissipated in the electronic device, and is in thermally conductive contact with the electronic component, to transfer, to the heat dissipation plate 10, the heat of the electronic component whose heat is to be dissipated. In FIG. 1, four heat dissipation regions are disposed on the first surface of the heat dissipation plate 10, and the four heat dissipation regions are circumferentially disposed. As shown in FIG. 1, the four heat dissipation regions are symmetrically disposed around a center of the heat dissipation plate 10. Each heat dissipation region has a triangular structure, and a vertex of the triangular structure faces the center of the heat dissipation plate 10. The four heat dissipation regions are respectively named a heat dissipation region 20a, a heat dissipation region 20b, a heat dissipation region 20c, and a heat dissipation region 20d. The heat dissipation region 20a and the heat dissipation region 20c are symmetrically disposed with respect to the center of the heat dissipation plate 10, and the heat dissipation region 20b and the heat dissipation region 20d are symmetrically disposed with respect to the center of the heat dissipation plate 10. For ease of description, the heat dissipation region 20a, the heat dissipation region 20b, the heat dissipation region 20c, and the heat dissipation region 20d may also be respectively referred to as a first heat dissipation region, a second heat dissipation region, a third heat dissipation region, and a fourth heat dissipation region. When the heat dissipation regions are specifically disposed, adjacent heat dissipation regions are spaced from each other by a gap. As shown in FIG. 1, when four heat dissipation regions are used, the four heat dissipation regions are disposed at intervals. The intervals between the heat dissipation regions are respectively a gap 30a, a gap 30b, a gap 30c, and a gap 30d. The gap 30a, the gap 30b, the gap 30c, and the gap 30d form an X-shaped ventilation channel, and the formed X-shaped ventilation channel passes through a center position of the heat dissipation plate 10.

As shown in FIG. 1, when four heat dissipation regions are used for the heat radiator, the four heat dissipation regions are circumferentially disposed, and a hollow region 40 is surrounded in the middle by the four heat dissipation regions. The hollow region 40 is located in a center region of the heat dissipation plate 10, and an "X"-shaped ventilation channel formed by gaps between different heat dissipation regions passes through the hollow region 40 and is connected to the hollow region 40. In addition, each heat dissipation region includes one heat dissipation channel, and the heat dissipation channel has an air inlet and an air outlet. The air outlet of the heat dissipation channel is in a direction that is above a channel formed by two adjacent first heat dissipation fins and that is towards the hollow region 40. The air inlet is away from the hollow region 40. Opening directions of air inlets in different heat dissipation regions in the four heat dissipation regions are different.

Optionally, when intervals between adjacent first heat dissipation fins in all regions are the same, heat dissipation channels in two heat dissipation regions that are disposed to be opposite to each other may be connected. For example, as shown in FIG. 1, in the heat dissipation region 20a and the heat dissipation region 20c, first heat dissipation fins in a same heat dissipation region are disposed at equal intervals and in parallel, so that heat dissipation channels that are disposed to be opposite to each other and that are in the heat dissipation region 20a and the heat dissipation region 20c are connected. Similarly, heat dissipation channels that are disposed to be opposite to each other and that are in the heat dissipation region 20b and the heat dissipation region 20d are also connected. Another connected heat dissipation channel is further formed in opposite heat dissipation regions in the foregoing heat radiator. When heat is unevenly generated in different regions of the component whose heat is to be dissipated, or when a same heat radiator dissipates heat for a plurality of components and the components generate heat differently, in the foregoing structure, another region may be used to assist in dissipating heat for a high-power heat dissipation region in the component whose heat is to be dissipated or a high-power component, thereby improving a heat dissipation effect of the heat radiator.

Optionally, in addition to four triangular heat dissipation regions with equal areas, the heat dissipation plate 10 shown in FIG. 1 may be divided into another quantity of heat dissipation regions, for example, three heat dissipation regions or five heat dissipation regions. When the heat radiator shown in FIG. 1 is divided into three heat dissipation regions, it may be understood that the heat dissipation region 20a and the heat dissipation region 20b in FIG. 1 are grouped into one heat dissipation region, and the heat dissipation region 20c and the heat dissipation region 20d each are used as an independent heat dissipation region. When five heat dissipation regions are used, it may be understood that any heat dissipation region in FIG. 1 is divided into two heat dissipation regions. However, regardless of how many heat dissipation regions are used, it is required to ensure that disposed heat dissipation regions are circumferentially disposed.

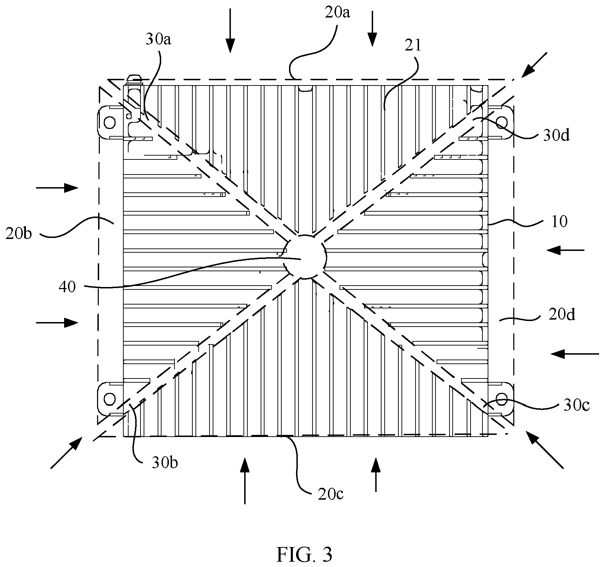

Next, the heat dissipation channel provided in this application is further described with reference to FIG. 1 and FIG. 2. Because the four heat dissipation regions provided in this application have a same structure, for brevity, one of the four heat dissipation regions is used as an example for description. Each heat dissipation region includes a plurality of heat dissipation fins 21 that are fixedly connected to the heat dissipation plate 10 and that are disposed at intervals. The heat dissipation fins 21 may also be referred to as first heat dissipation fins. The heat dissipation fins 21 may be welded to the first surface of the heat dissipation plate 10, or the heat dissipation fins 21 and the heat dissipation plate 10 are produced into an integral structure. As shown in FIG. 1, each heat dissipation fin 21 is a flat heat dissipation fin, and the heat dissipation fin 21 (a length direction) is perpendicular to the first surface of the heat dissipation plate 10. A plurality of heat dissipation fins 21 are disposed on the heat dissipation plate. The plurality of heat dissipation fins 21 are arranged in one row in parallel with each other, and an arrangement direction of heat dissipation fins 21 arranged in a single row is a length direction of one side edge of the first surface of the heat dissipation plate 10. For each heat dissipation fin 21, subject to an edge of the heat dissipation plate, lengths of different heat dissipation fins 21 in a same heat dissipation region gradually decrease based on a first threshold. The first threshold may be set based on a service requirement, or may be set based on the surface area of the electronic component whose heat is to be dissipated and the effective heat dissipation area of the heat dissipation plate. As shown in FIG. 3, the first heat dissipation fins 21 are flush or approximately flush at one end close to the side edge of the first surface of the heat dissipation plate 10. The first heat dissipation fins 21 are arranged into a ">" arrow shape at the other end, and a first heat dissipation fin 21 in the middle is a longest heat dissipation fin in the heat dissipation region. Lengths of the first heat dissipation fins 21 gradually decrease in a direction from the middle to two sides, so that the entire heat dissipation region forms a structure similar to an isosceles triangle.

Any two adjacent first heat dissipation fins 21 in a same heat dissipation region are spaced from each other by a gap, and a plurality of gaps form the foregoing heat dissipation channel. The heat dissipation channel may also be referred to as a first heat dissipation channel. When the heat dissipation fins 21 are arranged at intervals, the heat dissipation fins 21 are arranged at equal intervals. A width of the gap between the two adjacent heat dissipation fins 21 remains unchanged, that is, the gap is a linear gap and a width of the gap remains unchanged.

Optionally, in addition to the equal interval, the interval between the heat dissipation fins 21 in a same heat dissipation region may be set to an unequal interval. Space of the heat dissipation channel may be designed with reference to a specific implementation requirement, to effectively dissipate heat for a heat dissipation component of a specified model. In addition, the plurality of first heat dissipation fins are disposed at unequal intervals, so that a quantity of first heat dissipation fins in the heat radiator can also be reduced, thereby reducing a cost of the entire heat radiator.

Optionally, intervals between heat dissipation fins 21 in different heat dissipation regions may be the same or different, and may be set based on a specific requirement during specific implementation. Considering that different components whose heat is to be dissipated and different parts of a same heat dissipation component generate heat differently, the plurality of heat dissipation regions in the heat radiator may dissipate heat for different types of components whose heat is to be dissipated or for different parts of a same heat radiator. Considering heat dissipation effects of different heat dissipation regions on the component whose heat is to be dissipated or different parts of the component whose heat is to be dissipated, the intervals between the heat dissipation fins 21 in each heat dissipation region may be set based on a specific implementation requirement, to form different quantities of heat dissipation air ducts, thereby effectively dissipating heat for a high-power component whose heat is to be dissipated or different regions of a same component whose heat is to be dissipated.

FIG. 3 is a schematic diagram of air flow in a heat dissipation structure according to this application. When four heat dissipation regions surround the hollow region 40, air outlets of four heat dissipation channels surround the hollow region 40, the heat dissipation channels are arranged around the hollow region 40 in a radioactive pattern, and air enters air inlets of the four heat dissipation channels in different directions. For example, an air inlet in the heat dissipation region 20a faces upward, and air may enter a heat dissipation channel in the heat dissipation region 20a from top to bottom. An air inlet in the heat dissipation region 20c faces downward, and air may enter a heat dissipation channel in the heat dissipation region 20c from bottom to top. An air inlet in the heat dissipation region 20b faces leftward, and air may enter a heat dissipation channel in the heat dissipation region 20b from left to right. An air inlet in the heat dissipation region 20d faces rightward, and air may enter a heat dissipation channel in the heat dissipation region 20d from right to left. Length directions of the four heat dissipation channels are respectively perpendicular to edges of the first surface that is of the heat dissipation plate 10 and on which the heat dissipation channels are located.

During use, air outside the heat radiator enters the heat radiator in four directions: upward, downward, leftward, and rightward, and is converged in the hollow region 40 after passing through the foregoing four heat dissipation regions. It may be learned from a relationship between atmospheric pressure and temperature of air that atmospheric pressure of high-temperature air is relatively low and atmospheric pressure of low-temperature air is relatively high. In addition, when flowing through the heat dissipation regions, cold low-temperature air outside the heat radiator absorbs heat to form high-temperature air, and the high-temperature air is converged in the hollow region 40, so that atmospheric pressure in the hollow region 40 is relatively low, thereby forming a siphon cavity. As shown in FIG. 2 and FIG. 3, the siphon cavity is a cylindrical space region, and is connected to each of heat dissipation channels corresponding to the heat dissipation region 20a, the heat dissipation region 20b, the heat dissipation region 20c, and the heat dissipation region 20d. In addition, the siphon cavity is further connected to each of heat dissipation channels formed in the gap 30a, the gap 30b, the gap 30c, and the fourth gap 30d, and the heat dissipation channel may also be referred to as a second ventilation channel. When four heat dissipation regions are disposed in FIG. 3, air may enter the inside of the heat radiator in eight directions: upward, downward, leftward, rightward, upper left, upper right, lower left, and lower right. When flowing through the heat dissipation regions, cold low-temperature air outside the heat radiator absorbs heat on the first heat dissipation fins 21 to form high-temperature air. During air flow, because atmospheric pressure of the high-temperature air is relatively low, when the high-temperature air flows through the hollow region 40, the hollow region 40 becomes a low-pressure region. It may be learned from a principle of air flow that air flows from a high-pressure region to a low-pressure region. Therefore, the hollow region 40 can generate a siphon effect, thereby increasing an air flow speed in the heat dissipation channels. Due to adsorption of the siphon cavity, an air flow effect can be improved, thereby improving a heat dissipation effect. In the conventional technology, a technical solution is that air can enter the heat radiator only from a left side and a right side, cannot enter the heat radiator from a top side and a bottom side due to limitations of heat dissipation regions, and consequently a limited amount of air enters the heat radiator. Compared with the technical solution in the conventional technology, air enters in eight directions (upward, downward, leftward, rightward, upper left, upper right, lower left, and lower right), so that an amount of entered air can be effectively improved, thereby improving a heat dissipation effect of the heat radiator.

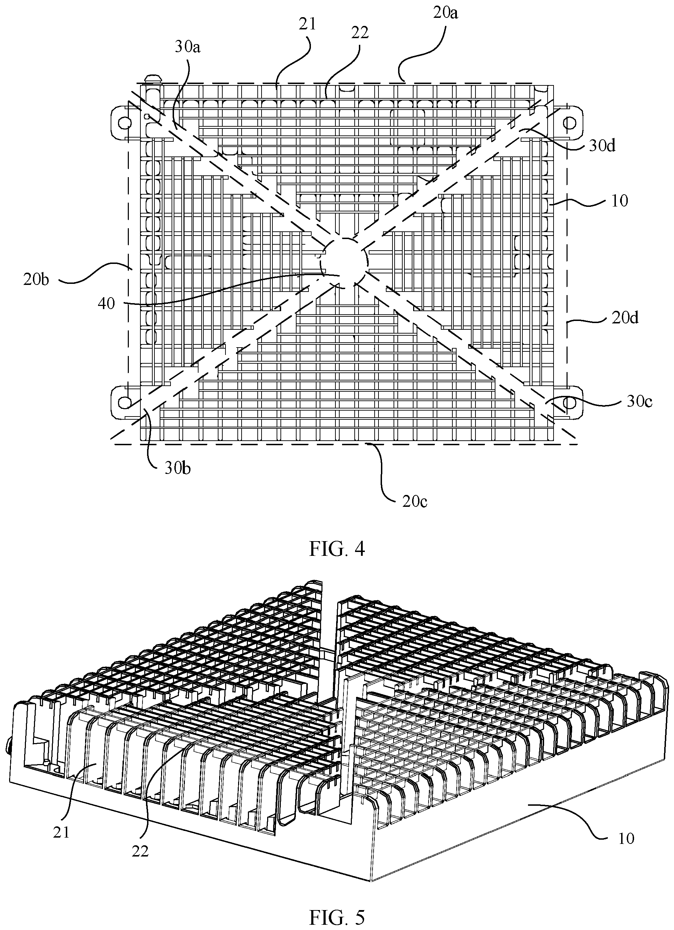

FIG. 4 is a schematic structural diagram of another heat radiator according to this application. For a reference numeral that is in the structure shown in the heat radiator shown in FIG. 4 and that is the same as the reference numeral in the structure shown in FIG. 1, refer to the descriptions in FIG. 1. As shown in FIG. 4, in addition to the heat dissipation fins 21 shown in FIG. 1, heat dissipation regions of the heat radiator shown in FIG. 4 include heat dissipation fins 22. The heat dissipation fins 22 may also be referred to as second heat dissipation fins. In FIG. 4, structures and areas of the heat dissipation regions are the same. For brevity, one of the heat dissipation regions is used as an example for description.

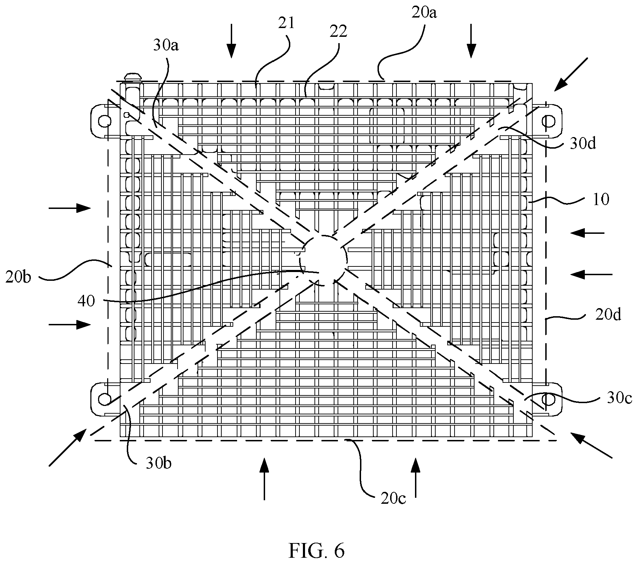

FIG. 5 is a schematic three-dimensional diagram of another heat radiator according to this application. FIG. 6 is a top view of a heat radiator according to this application. The heat dissipation region includes heat dissipation fins 21. For a disposing manner of the heat dissipation fins 21, refer to the related descriptions in FIG. 1. The heat dissipation region further includes heat dissipation fins 22 that are inserted in the heat dissipation fins 21, and the heat dissipation fins 22 are disposed at intervals. As shown in FIG. 4, the heat dissipation fin 22 also uses a flat heat dissipation fin, and the heat dissipation fin 21 is perpendicular to the heat dissipation fin 22. For example, the heat dissipation fin 21 (a length direction) is disposed to be perpendicular to the second heat dissipation fin 22 (a length direction). It should be understood that "the length direction of the heat dissipation fin 22 is perpendicular to the length direction of the first heat dissipation fin 21" is only a specific example. Optionally, the second heat dissipation fin 22 may be connected to the first heat dissipation fin 21 in another manner. For example, an included angle formed by connecting the length direction of the heat dissipation fin 21 to the heat dissipation fin 22 is different angles such as 30°, 45°, 60°, or 90°.

Optionally, to improve an effect of a fixed connection between the heat dissipation fin 21 and the heat dissipation fin 22, a slot may be disposed on the top (a part that is in a height direction of the heat dissipation fin 21 and that is away from the first surface) of the heat dissipation fin 21, and a row of slots are formed on the plurality of heat dissipation fins 21. Therefore, when the heat dissipation fin 21 is connected to the heat dissipation fin 22, the heat dissipation fin 22 is inserted in the slot and fastened. Specifically, an interference fit or different manners such as welding and riveting may be used. A plurality of rows of slots are formed on the plurality of heat dissipation fins 21, and the plurality of heat dissipation fins 22 are inserted in the rows of slots in a one-to-one correspondence manner, so that a grid shape is formed on a top wall of the heat dissipation fins 21.

Optionally, when the heat dissipation fin 22 is connected to the heat dissipation fin 21, in addition to a disposing manner of the heat dissipation fin 22 shown in FIG. 5, the heat dissipation fin 22 may be disposed to be stacked with the heat dissipation fin 21, and is fixedly connected to the heat dissipation fin 21 through welding or riveting.

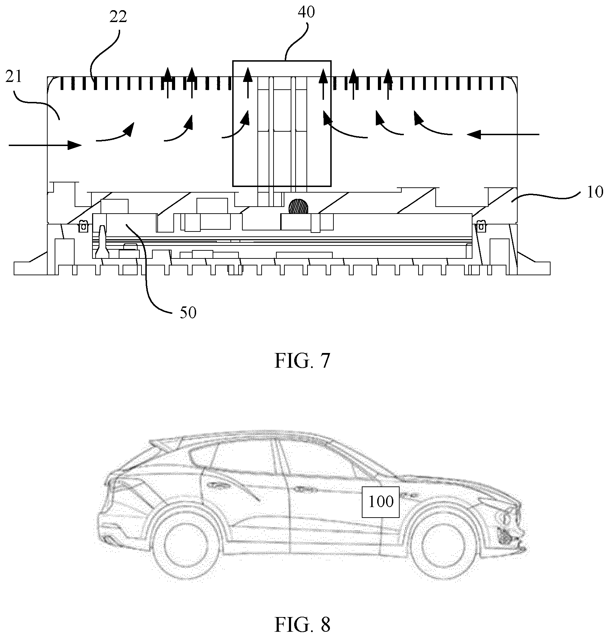

FIG. 7 is a sectional view of a structure in which a heat radiator dissipates heat for an electronic component whose heat is to be dissipated according to this application. FIG. 7 may be understood as a schematic sectional view of the heat radiator in a height direction of a heat dissipation fin. As shown in the figure, the heat radiator is thermally conductively connected to an electronic component 50 whose heat is to be dissipated. When a thermally conductive connection is specifically implemented, the electronic component 50 whose heat is to be dissipated is in direct contact with a heat dissipation plate 10 of the heat radiator, or is connected to a heat dissipation plate 10 by using thermal paste. Heat generated by the electronic component 50 whose heat is to be dissipated may be transferred to the heat dissipation plate 10, and is conducted, by using the heat dissipation plate 10, to heat dissipation channels formed by heat dissipation fins 21 and heat dissipation fins 22. The heat is removed through heat exchange between air flowing in the heat dissipation channels and the heat dissipation fins 21 and/or the heat dissipation fins 22. An arrow flow direction shown in FIG. 7 is an air flow direction. After cold air enters the heat dissipation channels from a channel between the heat dissipation fins 21, the cold air is heated by the heat dissipation fins 21 to become hot air, and a part of the hot air rises up. When the hot air passes through the heat dissipation fins 22, heat of the heat dissipation fins 22 is removed. The other part of the hot air continues to flow in the heat dissipation channels until the hot air flows into a siphon cavity and then rises up. It may be learned from the foregoing description that, when the heat dissipation fin 22 is disposed, the heat dissipation fin 22 should not be excessively high. Otherwise, wind entering from the channel between the heat dissipation fins 21 is blocked. The heat dissipation fin should not be excessively short either. Otherwise, a limited heat transfer area is increased. Therefore, when the heat dissipation fin 22 is disposed, a height of the heat dissipation fin 22 is 10% to 15% of a height of the heat dissipation fin 21, so that there can be a sufficient distance between the heat dissipation fin 22 and the heat dissipation plate 10, for example, different distances such as 3 mm, 4 mm, 5 mm, 7 mm, and 8 mm. Specifically, optimization may be performed based on a size of the heat radiator.

When the heat dissipation fin 21 and the heat dissipation fin 22 are specifically disposed, a thickness of the heat dissipation fin 21 is greater than a thickness of the heat dissipation fin 22. Because the heat dissipation fin 21 is relatively thick, a coefficient (which is usually 120 wmK) of thermal conductivity is relatively high, so that a temperature difference between the top and the bottom of the heat dissipation fin 21 is relatively small, heat can be better transferred to the heat dissipation fin 22, and the heat dissipation fin 22 can effectively expand a heat dissipation area. In addition, the heat dissipation fin 22 is inserted in the top of the heat dissipation fin 21, and is thin and short. This hardly impedes air flow between the heat dissipation fins 21, and does not reduce a convective heat transfer coefficient $h_c$. For example, in a specific implementable solution, the thickness of the first heat dissipation fin 21 is between 1.8 mm and 2.2 mm, and the thickness of the heat dissipation fin 22 is between 0.8 mm and 1 mm. More specifically, the thickness of the heat dissipation fin 21 may be a thickness such as 1.8 mm, 2.0 mm, and 2.2 mm, and the thickness of the heat dissipation fin 22 may be a thickness such as 0.8 mm, 0.9 mm, and 1 mm.

Optionally, a quantity of heat dissipation fins 22 in each heat dissipation region may be determined based on an actual situation. When the heat dissipation fin 22 is relatively thin, more heat dissipation fins 22 may be disposed in each heat dissipation region, to increase a surface area for conducting heat of the heat dissipation plate. When the heat dissipation fin 22 is relatively thick, fewer heat dissipation fins 22 may be disposed, to prevent the disposed second heat dissipation fins 22 from affecting air flow. However, regardless of how many heat dissipation fins 22 are used, a cooling effect is relatively good when an interval between the heat dissipation fins 22 is 5 mm. In this case, the added second heat dissipation fins 22 do not impose a great impact on air flow, and a heat dissipation area is also increased.

In a possible embodiment, in addition to the foregoing manner, the heat radiator may be divided into a plurality of heat dissipation regions in another form. For example, midpoints of opposite edges of the heat radiator are connected to each other to form a "cross" structure, and a hollow region similar to the hollow region shown in FIG. 1 exists in a center part, to help form a siphon cavity. Each heat dissipation region also includes a plurality of first heat dissipation fins, and a first heat dissipation channel is formed between two adjacent heat dissipation fins. A second heat dissipation channel is formed in a gap between different heat dissipation regions. Optionally, a thermally conductive area may be increased by using second heat dissipation fins, to improve a thermally conductive effect.

It may be learned from the foregoing description that in the heat radiator shown in FIG. 4 and FIG. 5, the heat dissipation area is increased by adding the heat dissipation fins 22, and the added heat dissipation fins 22 do not reduce air flow. The heat dissipation fins 22 may also assist the heat dissipation fins 21 in conducting heat emitted by the component whose heat is to be dissipated, thereby implementing a better heat dissipation effect.

FIG. 7 is a schematic diagram of an electronic device according to this application. The electronic device includes a device body, an electronic component whose heat is to be dissipated, and the heat radiator that is disposed on the device body and that is in any one of the foregoing embodiments. The electronic device may be the foregoing in-vehicle computation apparatus or another computation module. However, regardless of any one of the foregoing specific structures is used, heat dissipation is performed for the electronic device by using a plurality of heat dissipation regions, and opening directions of air inlets in different heat dissipation regions are different, so that a quantity of air inlets of the heat radiator is increased, and air can enter in different directions, thereby improving a heat dissipation effect.

Optionally, in the electronic device shown in FIG. 7, the device body and the heat dissipation plate 10 have an integral structure. In this case, a housing of the device body may be used as the heat dissipation plate 10 of the heat radiator, and a top surface of the electronic component 50 whose heat is to be dissipated may be directly pressed against the heat dissipation plate 10, and may perform thermal conduction with the heat dissipation plate 10. Alternatively, the electronic component 50 whose heat is to be dissipated may be connected to the heat dissipation plate 10 by using thermal adhesive, and heat generated by the electronic component 50 whose heat is to be dissipated may be transferred to the heat dissipation plate 10 by using the thermal adhesive.

FIG. 8 is a schematic diagram of a vehicle according to this application. As shown in the figure, the vehicle includes a vehicle body, and the heat radiator that is disposed in the vehicle body and that is in any one of the foregoing embodiments or the electronic device 100 that is disposed in the vehicle body. Heat dissipation is performed by using at least three heat dissipation regions, and opening directions of air inlets in different heat dissipation regions are different, so that a quantity of air inlets of the heat radiator is increased, and air can enter in different directions, thereby improving a heat dissipation effect.

In a possible embodiment, in addition to the vehicle shown in FIG. 8, the heat radiator disclosed in this application may be used in another type of system, for example, an edge small-cell device, a server, and a storage device. During specific implementation, references can be to the structural feature of the heat radiator mentioned in the foregoing embodiments. A size of the heat radiator is designed based on an area of the electronic component whose heat is to be dissipated, and a quantity of air inlets and a quantity of air outlets are increased by using a structure with a plurality of heat dissipation regions, thereby improving a heat dissipation effect on the component whose heat is to be dissipated.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1.   A heat radiator, comprising a heat dissipation plate, wherein the heat radiator has a plurality of heat dissipation regions disposed circumferentially, each heat dissipation region has a plurality of first heat dissipation fins disposed in parallel with each other, the first heat dissipation fins adjacent in each heat dissipation region form a first heat dissipation channel, one end that is of the first heat dissipation channel and that is away from a center of the heat dissipation plate is an air inlet, and a direction that is above each heat dissipation channel and that is towards a hollow region is an air outlet.

2.   The heat radiator according to claim 1, wherein the plurality of first heat dissipation fins in each heat dissipation region are arranged at equal intervals.

3.   The heat radiator according to claim 1 or 2, wherein opening directions of air inlets of heat dissipation channels in different heat dissipation regions are different.

4.   The heat radiator according to any one of claims 1 to 3, wherein the plurality of first heat dissipation fins in each heat dissipation region are arranged in a single row, and lengths of the plurality of first heat dissipation fins gradually decrease from the middle to two sides.

5.   The heat radiator according to any one of claims 1 to 4, wherein adjacent heat dissipation regions are spaced from each other by a gap, and a second heat dissipation channel is formed between the adjacent heat dissipation regions.

6.   The heat radiator according to any one of claims 1 to 5, wherein the heat radiator is divided into four heat dissipation regions in a diagonal intersection manner, the four heat dissipation regions are symmetrically disposed, and areas of the heat dissipation regions are the same.

7.   The heat radiator according to claim 6, wherein when adjacent heat dissipation regions are spaced from each other by a gap, gaps between the heat dissipation regions form an X-shaped ventilation channel.

8.   The heat radiator according to any one of claims 1 to 7, wherein a hollow siphon cavity is surrounded by the plurality of heat dissipation regions on the heat dissipation plate, air outlets in the plurality of heat dissipation regions are connected to the siphon cavity, and the siphon cavity is configured to generate a low-pressure region to increase an air flow speed in the heat dissipation channel.

9.   The heat radiator according to any one of claims 1 to 8, wherein each heat dissipation region further comprises a plurality of second heat dissipation fins that are disposed at intervals and that are inserted in the plurality of first heat dissipation fins, and a length direction of each second heat dissipation plate is unparallel with a length direction of each first heat dissipation fin.

10.   The heat radiator according to claim 9, wherein the length direction of the second heat dissipation fin is perpendicular to the length direction of the first heat dissipation fin.

11.   The heat radiator according to claim 9 or 10, wherein a slot is disposed on one side that is of the first heat dissipation fin and that is away from the heat dissipation plate, and the second heat dissipation fin is inserted in the slot.

12.   The heat radiator according to any one of claims 9 to 11, wherein a height of the second heat dissipation fin is 10% to 15% of a height of the first heat dissipation fin.

13.   The heat radiator according to any one of claims 9 to 12, wherein a thickness of the first heat dissipation fin is greater than a thickness of the second heat dissipation fin.

14.   The heat radiator according to any one of claims 9 to 13, wherein an interval between adjacent heat dissipation fins of the second heat dissipation fins is 5 mm to 10 mm

**15.** The heat radiator according to any one of claims 1 to 14, wherein the heat radiator and an electronic component whose heat is to be dissipated are thermally conductively connected to each other, and heat generated by the electronic component is transferred to the first heat dissipation fins or the second heat dissipation fins by using the heat dissipation plate; and

the heat is removed through heat exchange between air flowing in the heat dissipation channel and the first heat dissipation fins or the second heat dissipation fins.

**16.** An electronic device, comprising a device body, an electronic component whose heat is to be dissipated, and the heat radiator that is disposed on the device body and that is according to any one of claims 1 to 15.

**17.** The electronic device according to claim 16, wherein the device body and the heat dissipation plate have an integral structure.

**18.** A vehicle, comprising a vehicle body, and the heat radiator that is disposed in the vehicle body and that is according to any one of claims 1 to 15 or the electronic device that is disposed in the vehicle body and that is according to claim 16 or 17.

FIG. 1

FIG. 2

FIG. 3

FIG. 4

FIG. 5

FIG. 6

FIG. 7

FIG. 8

## INTERNATIONAL SEARCH REPORT

| International application No. |
| --- |
| **PCT/CN2020/081529** |

**A. CLASSIFICATION OF SUBJECT MATTER**

H05K 7/20(2006.01)i

According to International Patent Classification (IPC) or to both national classification and IPC

**B. FIELDS SEARCHED**

Minimum documentation searched (classification system followed by classification symbols)

H05K

Documentation searched other than minimum documentation to the extent that such documents are included in the fields searched

Electronic data base consulted during the international search (name of data base and, where practicable, search terms used)

CNABS, VEN, CNTXT, USTXT, EPTXT, WOTXT, CNKI: 散热, 冷却, 鳍片, 翅片, 风道, 通道, 交叉, 中央; cool, radiator, heat sink, fin, air, flow, path, channel, cross, center

**C. DOCUMENTS CONSIDERED TO BE RELEVANT**

| Category* | Citation of document, with indication, where appropriate, of the relevant passages | Relevant to claim No. |
| --- | --- | --- |
| X | CN 206371029 U (KMW INC.) 01 August 2017 (2017-08-01) description, paragraphs 0010, 0059-0061, 0088-0094, figures 6, 7 | 1-8, 15-18 |
| Y | CN 206371029 U (KMW INC.) 01 August 2017 (2017-08-01) description, paragraphs 0010, 0059-0061, 0088-0094, figures 6, 7 | 9-18 |
| Y | CN 104602490 A (HUAWEI TECHNOLOGIES CO., LTD.) 06 May 2015 (2015-05-06) description, paragraphs 0029-0031, figures 2, 3 | 9-18 |
| X | CN 1641867 A (TAIDA ELECTRONICS INDUSTRY CO., LTD.) 20 July 2005 (2005-07-20) description, page 3, line 24 to page 5, line 8, figures 2A-3C | 1-8, 15-18 |
| PX | CN 110545648 A (HUAWEI TECHNOLOGIES CO., LTD.) 06 December 2019 (2019-12-06) claims 1-18 | 1-18, |
| A | CN 103827579 A (SAMSUNG ELECTRONICS CO., LTD.) 28 May 2014 (2014-05-28) entire document | 1-18, |
| A | US 2010108292 A1 (TELEDYNE SCIENT & IMAGING LLC) 06 May 2010 (2010-05-06) entire document | 1-18, |
| A | US 6418020 B1 (ADVANCED THERMAL TECHNOLOGIES) 09 July 2002 (2002-07-09) entire document | 1-18, |

☐ Further documents are listed in the continuation of Box C.　☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | |
| "O" document referring to an oral disclosure, use, exhibition or other means | "Y" document of particular relevance; the claimed invention cannot be considered to involve an inventive step when the document is combined with one or more other such documents, such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| **04 June 2020** | **11 June 2020** |

| Name and mailing address of the ISA/CN | Authorized officer |
| --- | --- |
| **China National Intellectual Property Administration (ISA/CN)** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/081529**

| Patent document cited in search report | | | Publication date (day/month/year) | Patent family member(s) | | | Publication date (day/month/year) |
|---|---|---|---|---|---|---|---|
| CN | 206371029 | U | 01 August 2017 | JP | 6526067 | B2 | 05 June 2019 |
| | | | | KR | 20150145084 | A | 29 December 2015 |
| | | | | US | 2017097196 | A1 | 06 April 2017 |
| | | | | WO | 2015194897 | A1 | 23 December 2015 |
| | | | | JP | 2017521861 | A | 03 August 2017 |
| CN | 104602490 | A | 06 May 2015 | BR | 112017015049 | A2 | 20 March 2018 |
| | | | | EP | 3240385 | A1 | 01 November 2017 |
| | | | | WO | 2016112648 | A1 | 21 July 2016 |
| | | | | EP | 3240385 | A4 | 17 January 2018 |
| | | | | US | 2017314877 | A1 | 02 November 2017 |
| | | | | EP | 3240385 | B1 | 26 February 2020 |
| | | | | CN | 104602490 | B | 22 September 2017 |
| CN | 1641867 | A | 20 July 2005 | CN | 100347848 | C | 07 November 2007 |
| CN | 110545648 | A | 06 December 2019 | None | | | |
| CN | 103827579 | A | 28 May 2014 | WO | 2013027872 | A1 | 28 February 2013 |
| | | | | US | 2014192537 | A1 | 10 July 2014 |
| | | | | DE | 112011105546 | T5 | 08 May 2014 |
| US | 2010108292 | A1 | 06 May 2010 | None | | | |
| US | 6418020 | B1 | 09 July 2002 | None | | | |

Form PCT/ISA/210 (patent family annex) (January 2015)